# EUROPEAN PATENT APPLICATION

(11) **EP 2 241 534 A2**
(43) Date of publication of application: **20.10.2010**
(21) Application number: 09704709.6
(22) Date of filing: 21.01.2009
(51) Int. Cl.: B82B 3/00, C30B 29/02, C30B 23/00, C30B 29/60, C30B 29/62, B22F 1/00

(54) **METHOD FOR MANUFACTURING BISMUTH SINGLE CRYSTAL NONOWIRES**

(30) Priority: 24.01.2008 KR 20080007372
(71) Applicant: Korea Advanced Institute of Science and Technology, Daejeon 305-701 (KR)
(72) Inventor: KIM, Bongsoo, Daejeon 305-701 (KR); IN, Juneho, Daejeon 305-701 (KR)
(74) Representative: Stolmár, Matthias
(86) International application number: PCT/KR2009/000310
(87) International publication number: WO 2009/093842

(57) **Abstract**

Provided is a fabrication method of a single crystalline bismuth nanowire, in which a bismuth nanowire of a single crystal is fabricated on a substrate by vaporizing bismuth powder.

Since it is possible to fabricate a single crystalline bismuth nanowire which is a semimetal not using a template having nanopores but using a vapor-phase transport process, this synthesis method has advantages that the process is simple and reproducible, the fabricated nanowire shows high purity and quality with perfect single crystallinity, and it is possible to produce the bismuth nanowires with an uniform size which are not coagulated on a single crystalline substrate.

## Description

### CROSS-REFERENCE(S) TO RELATED APPLICATIONS

The present invention claims priority of Korean Patent Application No. 10-2008-007372, filed on January 24, 2008, which is incorporated herein by reference.

### BACKGROUND OF THE INVENTION

### Field of the Invention

The present invention relates to a fabrication method of single crystalline bismuth nanowire through nucleation and growth of bismuth by vaporizing bismuth (Bi) powder and then transferring the vaporized bismuth to a substrate.

### Description of Related Art

Bismuth (Bi) is a semimetal, which has unique properties of small effective electron mass, low thermal conductivity, long mean free path (about 0.1 mm at 4K and about 100 nm at 300K) and low electron density (about 3X10¹⁷ cm⁻³) and so on. Accordingly, there has been actively studied an electron transport property exhibited due to a quantum confinement effect in a thermoelectric material and a single dimensional structure.

Particularly, since the bismuth with a diameter of less than 50 nm has a property of a semiconductor having a band gap (semimetal to semiconductor transition) and shows a magnetoresistance property though it is not a magnetic material, there have been made fabrication of a single dimensional bismuth nanowire using a template formed with nanopores or an electron beam and study for electrical and magnetic properties of the bismuth in the form of a nanowire.

However, the conventional fabrication of the bismuth nanowire using the template formed with nanopores or using an electrochemical method has a problem that a polycrystalline bismuth nanowire can be formed and a problem that the fabrication is complex since it is required to fabricate the template having the minute and uniform nanopores and remove the template after the fabrication of the nanowire and mass production thereof is difficult.

### SUMMARY OF THE INVENTION

An embodiment of the present invention is directed to providing a fabrication method of a high purity, high quality single crystalline bismuth (Bi) nanowire not using a template but using a vapor-phase transport process.

Another embodiment of the present invention is directed to providing a fabrication method of a high purity, high quality single crystalline bismuth (Bi) nanowire which has a simple and reproducible process and is mass producible.

Another embodiment of the present invention is directed to providing a single crystalline bismuth nanowire fabricated using the fabrication method of the present invention.

To achieve the object of the present invention, the present invention provides a fabrication method of a single crystalline bismuth nanowire, in which a bismuth nanowire of a single crystal is fabricated on a substrate by vaporizing bismuth powder.

In the fabrication method of a single crystalline bismuth nanowire, the bismuth powder and the substrate are heat treated at different temperatures, the bismuth powder is vaporized and the vaporized bismuth is transported to the substrate using a carrier gas(inert gas), and the transported bismuth is then nucleated and grown on the substrate, thereby fabricating the single crystalline bismuth nanowire.

Therefore, according to the fabrication method of the present invention, since the single crystalline bismuth nanowire is fabricated not using a template formed with nanopores but through a vapor-phase transport path, there are advantages that a process is simple and reproducible and it is possible to fabricate a high purity nanowire including no impurity.

Also, since this method controls the temperatures of the bismuth powder and the substrate respectively, controls a flow rate of the carrier gas (inert gas) and a pressure in a reactor, and thus finally controls nucleation driving force, growth driving force, nucleation rate and growth rate of the bismuth on the substrate, a size of the single crystalline bismuth nanowire and a density thereof on the substrate are controllable and reproducible and it is possible to fabricate high quality single crystalline bismuth nanowire having no defect and good crystallinity.

Essential conditions for fabricating the bismuth nanowire of a high quality, a high purity and a preferred shape is temperatures of the bismuth powder and the substrate, a flow rate of the carrier gas and a pressure upon the heat treatment.

Preferably, the bismuth powder is placed in a front portion of a reactor and maintained at 600 to 800 °C, and the substrate is placed in a rear portion of the reactor and maintained at 100 to 200 °C. Preferably, the inert gas, which functions as a carrier for transporting the vaporized bismuth to the substrate, flows at 100 to 600 sccm from the front portion of the reactor to the rear portion of the reactor. Preferably, the pressure in the reactor is 1 to 30 torr.

Though the temperature upon heat treatment, the flow rate of the inert gas and the pressure upon the heat treatment can be varied independently of one another, it is possible to obtain a single crystalline bismuth nanowire of preferred quality and shape when the three conditions are varied depending on other conditions.

The temperature upon heat treatment, the flow rate of the inert gas and the pressure upon the heat treatment have an influence on a vaporization degree of the bismuth powder, an amount of vaporized bismuth material transported to the substrate per hour, nucleation and growth rate of the bismuth material on the substrate, a surface energy of the bismuth solid phase (nanowire) generated on the substrate, coagulation degree of the bismuth solid phase (nanowire) generated on the substrate and a morphology of the bismuth solid phase generated on the substrate.

When the conditions are out of the aforementioned ranges, quality problems such as coagulation of the fabricated nanowires, shape deformation, defect can be generated and a Bi body not the form of a nanowire but in the form of a particle or a rod can be obtained.

Heat treatment time is controlled in consideration of a size of the bismuth nanowire to be fabricated and the conditions of the temperature, flow of the inert gas and pressure upon the heat treatment, and is preferably performed for 5 minutes to 1 hour.

The substrate is a semi-conductive or non-conductive substrate, preferably a single crystalline semiconductor or nonconductive substrate and more preferably a silicon single crystalline substrate.

By the heat treatment, a bismuth nanowire of a rhombohedral structure is fabricated, a bismuth nanowire of which major axis (length direction of nanowire) is <110> direction is fabricated and a bismuth nanowire having a diameter in a minor axis of 50 to 300 nm and a length in the major axis of several µm.

The fabrication method of the present invention, since it is possible to fabricate a single crystalline bismuth nanowire which is a semimetal not using a template having nanopores but using a vapor-phase transport process, has advantages that the process is simple and reproducible, the fabricated nanowire is a high purity, high quality bismuth nanowire of perfect single crystallinity with no defect and it is possible to mass product the bismuth nanowire of a uniform size which is not coagulated on a substrate.

### BRIEF DESCRIPTION OF THE DRAWINGS

Fig. 1 is a schematic diagram illustrating a fabrication method of a bismuth nanowire in accordance with an embodiment of the present invention.

Fig. 2 shows a low resolution Scanning Electron Microscope (SEM) photograph (a) and a high resolution SEM photograph (b) of a bismuth nanowire fabricated through Example 1.

Fig. 3 is an X-ray diffraction pattern of the bismuth nanowire fabricated through Example 1.

Fig. 4 is a photograph (dark field image) by Transmission Electron Microscope (TEM) showing the bismuth nanowire fabricated through Example 1, in which the upper right portion of Fig. 4 is a Selected Area Electron Diffraction pattern (SAED) of the bismuth nanowire of Fig. 4.

Fig. 5 is a photograph by High Resolution Transmission Electron Microscope (HRTEM) showing the bismuth nanowire fabricated through Example 1.

Fig. 6 is an analysis result of Energy Dispersive Spectroscopy (EDS) of the bismuth nanowire fabricated through Example 1.

### DESCRIPTION OF SPECIFIC EMBODIMENTS

The advantages, features and aspects of the invention will become apparent from the following description of the embodiments with reference to the accompanying drawings, which is set forth hereinafter.

Unless defined otherwise, all technical and scientific terms used herein have the same meanings as commonly understood by one of ordinary skill in the art to which the present invention belongs. In other instances, well known functions and structures have not been described in detail in order not to unnecessarily obscure the present invention.

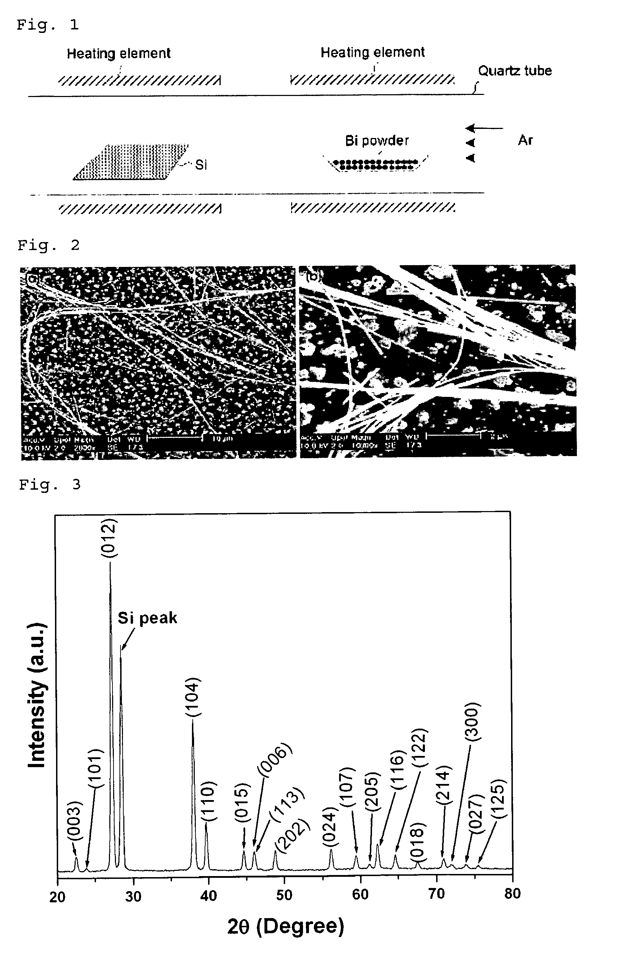

Fig.1 is a schematic diagram showing a fabrication method in accordance with an embodiment of the present invention. As shown in Fig.1, bismuth (bi) powder contained in a refractory crucible (alumina crucible) is placed in the front portion of a reactor and a substrate is placed in the rear portion of the reactor. After that, a temperature of the front portion of the reactor (bismuth powder) is maintained at 600 to 80 °C and a temperature of the rear portion of the reactor (substrate) is maintained at 100 to 200 °C using respective heating elements therefor. Bismuth gas is generated by heating of the bismuth powder, and the vaporized bismuth is transported to the substrate by flow of an inert gas (Ar of Fig. 1) flowing from the front portion of the reactor to the rear portion of the reactor. a nucleation rate and a growth rate of solid-phase bismuth nucleated on the substrate are determined by the temperature of the substrate and an amount of the bismuth gas transported to the substrate. It is preferred to flow the inert gas at a flow rate of a 100 to 600 sccm under a pressure of 1 to 30 torr in order to transport the vaporized bismuth.

At this time, when the temperature of the substrate is too low or the amount of the transported bismuth gas is too much, it is difficult to fabricate a nanowire having a preferred aspect ratio, and not the nanowire but a nanoparticle or a nanorod can be fabricated.

The temperatures in the front portion (bismuth powder) and the rear portion (substrate) of the reactor, a flow rate of the inert gas and a pressure (a pressure of an inside of a heat treatment tube of the reactor, or a pressure in an inside of the quartz tube of Fig. 1) upon heat treatment are the conditions under which a bismuth nanowire is fabricated on the substrate and the condition for keeping dynamic equilibrium of generation and driving forces of the nanowire. Under the aforementioned conditions, the bismuth nanowire fabricated on the substrate is fabricated into the form of a high purity, high quality single crystalline nanowire which is not coagulated with one another, and has a preferred aspect ratio.

Although in Fig.1 separate heating elements are employed in the front portion and the rear portion of the reactor to independently control the temperature of the crucible(for example, high purity alumina crucible) containing the bismuth powder and the temperature of the substrate, it is possible to locate the crucible containing the bismuth powder at a portion with a highest temperature in the quartz tube in an inside of the furnace and control a physical distance between the crucible and the substrate, thereby controlling the temperature condition of the substrate.

At this time, the substrate can be any semiconductor or nonconductor having high thermal, chemical stabilities at 100 to 200 °C, preferably a single crystalline semiconductor or nonconductor, and more preferably a silicon single crystalline substrate.

### (Example 1)

A single crystalline bismuth nanowire was synthesized in a reactor using bismuth powder.

The reactor is divided into a front portion and a rear portion respectively provided with a heating element and a temperature controller. A tube in an inside of the reactor was made of quartz and had a size of 1 inch in diameter and 60 cm in length.

A boat type crucible of a high purity alumina material containing 0.20 g of bismuth powder (Sigma-Aldrich, 264008) therein was placed in the middle of the front portion of the reactor and a silicon substrate (0.5 cm X 0.5 cm) was placed in the middle of the rear portion of the reactor. As a substrate, a silicon wafer having a (100) crystalline plane on which native oxides are formed was used. Argon gas is inputted into the front portion of the reactor and is discharged from the rear portion of the reactor, and the rear portion of the reactor is provided with a vacuum pump. The pressure in an inside of the quartz tube was maintained at 15 torr using the vacuum pump and Ar was controlled to flow at 300 sccm using a Mass Flow Controller (MFC).

Heat treatment was performed for 20 min with the temperature of the front portion of the reactor (alumina crucible containing bismuth powder therein) being maintained at 700 °C and the rear portion of the reactor (silicon substrate) being maintained at 150 °C to fabricate a single crystalline bismuth nanowire.

Fig. 2 shows a low resolution SEM photograph (a) and a high resolution SEM photograph (b) of a bismuth nanowire fabricated through Example 1. From Fig. 2, it can be appreciated that a solid nanowire having a diameter of about 100 nm and a length of tens µm was fabricated and it can also be seen that a plurality of the fabricated nanowires is separately fabricated on the silicon substrate with regular size and shape and no coagulation with one another.

Fig. 3 is an X-ray diffraction pattern of the bismuth nanowire fabricated through Example 1. It can be appreciated that an X-ray diffraction peak of the fabricated bismuth nanowire is equal to that of bulk bismuth and it can also be appreciated that the fabricated bismuth nanowire has a rhombohedral structure.

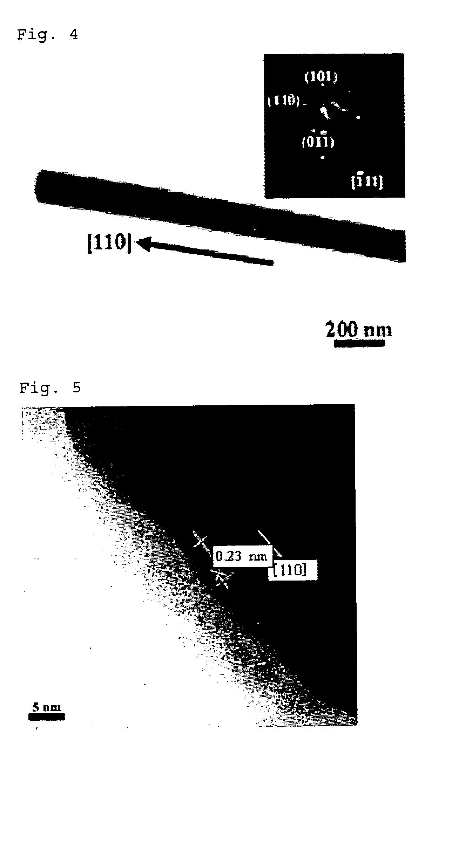

Fig. 4 is a photograph (dark field image) by Transmission Electron Microscope (TEM) showing the bismuth nanowire fabricated through Example 1, in which the upper right portion of Fig. 4 is a Selected Area Electron Diffraction pattern (SAED) of the bismuth nanowire of Fig. 4. From the dark field image of Fig. 4, it can be appreciated that the fabricated nanowire has a smooth surface and the fabricated nanowire has a regular thickness. From the SAED result of Fig. 4, it can be appreciated that the single nanowire is of a single crystal and has a rhombohedral structure like the X-ray diffraction result of Fig. 3. Also, from the dark field image and SAED of Fig. 4, it can be appreciated that a direction of length of the bismuth nanowire (direction of major axis) is <110> direction.

Fig. 5 is a photograph by High Resolution Transmission Electron Microscope (HRTEM) showing the bismuth nanowire fabricated through Example 1. From Fig. 5, it can be appreciated that the nanowire of a single crystal was fabricated, which is the same result as the X-ray diffraction pattern of the Fig. 3 and the SAED of Fig. 4, and the single crystal bismuth in a nanowire form has a high crystallinity with defect including twin(2-dimensional defect). Also, it can be appreciated that a lattice spacing of the (110) plane, which corresponds to the growth direction of the bismuth nanowire, is 0.23 nm which is the same as that of the bulk bismuth.

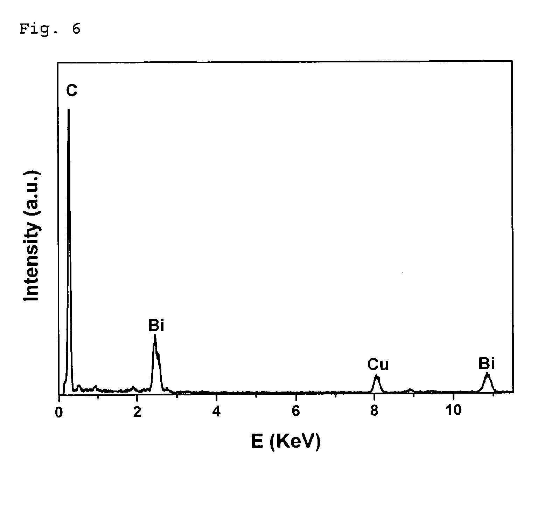

Fig. 6 is a result of analyzing a composition of the bismuth nanowire fabricated through Example 1 using an EDS equipped in the TEM. From Fig. 6, it can be appreciated that a nanowire made of a high purity bismuth, except for substance such as a grid auxiliarily measured due to a property of the measuring equipment, was fabricated and the silicon which is a substance forming the substrate does not present as an impurity.
While the present invention has been described with respect to the specific embodiments, it will be apparent to those skilled in the art that various changes and modifications may be made without departing from the spirit and scope of the invention as defined in the following claims.

## Claims

1. A fabrication method of a single crystalline bismuth nanowire, wherein a single crystalline bismuth nanowire is fabricated on a substrate by vaporizing bismuth powder and transporting the vaporized bismuth to the substrate.

2. The method of claim 1, the bismuth powder is placed in a front portion of a reactor and maintained at 600 to 800 °C, and the substrate is placed in a rear portion of the reactor and maintained at 100 to 200 °C.

3. The method of claim 2, wherein a carrier gas flows at 100 to 600 sccm from the front portion of the reactor to the rear portion of the reactor.

4. The method of claim 3, wherein a pressure in the reactor is 1 to 30 torr.

5. The method of claim 1, wherein the substrate is a nonconductive substrate or a semiconductive substrate.

6. The method of claim 1, wherein the bismuth nanowire is rhombohedral structure.

7. The method of claim 1, wherein the bismuth nanowire has <110> major axis.

8. The method of claim 1, wherein the bismuth nanowire has a diameter in a minor axis of 50 to 300 nm.

9. A single crystalline bismuth nanowire fabricated by the method of any one of claims 4.
